# EUROPEAN PATENT SPECIFICATION

(11) **EP 2 159 806 B1**
(45) Date of publication and mention of the grant of the patent: **19.12.2012**
(21) Application number: 08015027.9
(22) Date of filing: 26.08.2008
(51) Int. Cl.: H01G 2/04

(54) **Mounting arrangement for electric components**
Montageanordnung für elektrische Komponenten
Agencement de montage pour composants électriques

(43) Date of publication of application: 03.03.2010
(73) Proprietor: Autoliv Development AB, 447 83 Vårgårda (SE)
(72) Inventor: Dunk, Stephen, 92600 Asnières sur Seine (FR)
(74) Representative: Müller Verweyen

(56) References cited:
- WO-A-00/16351
- WO-A-01/17069
- WO-A-2007/012644
- DE-A1- 19 829 920

## Description

The invention concerns a mounting arrangement for electric components according to the features of the preamble of claim 1.

Mounting arrangements for electric components in housings of electronic control units are in general known.

In FR 2 770 739 it is disclosed a mounting arrangement, which comprises two cradles and fingers with different length to hold the component in position. The different lengths of the fingers enable the fixation of the components with different diameters in the same cradle.

This design has the disadvantage that the component can move along the length axis and is therefore not fixed properly. Especially when the electronic control unit (ECU) is exposed to heavy vibrations, for in example when the ECU is mounted in a vehicle, and the vehicle drives on a street with a bad surface, it is possible that the component moves out of his position and the contact to other components is destroyed.

Another mounting arrangement is known from DE 198 29 920 A.

Therefore it is the object of the invention to provide a mounting arrangement for a component in a housing of an electronic control unit, where the component is mounted properly in the predetermined position also when mechanical forces like vibrations act on the ECU.

The invention propose, the mounting arrangement according to claim 1. Therefore it is prevented, that the component may move out of its predetermined position perpendicular to or along the length axis of the component when the ECU is exposed to heavy vibrations.

It is suggested, that the mounting arrangement comprise at least one pair of first arms with ribs reducing the distance between them. By providing the ribs at the first arms it is possible to mount components with different length in one mounting arrangement without changing the mounting arrangement. When a component with a shorter length is mounted, the ribs act as axial abutments to fix the component in axial direction. The mounting arrangement can therefore be designed for components with many different lengths while for each length of the component one pair of ribs act as abutment. In case of mounting a shorter component, the ribs acting as abutment replacing the second arm in the function to fix the component in axial direction.

The mounting arrangement is especially reasonable when the component is a capacitor, because capacitors are usually the biggest components in the ECU and are exposed to the biggest forces due to their own mass and dimensions.

It is furthermore suggested that the first and/or second arms are flexible, to enable an easy fixation by bending the arms out of their position and to create the necessary spring force in the mounted position of the component.

Another preferred embodiment of the invention can be seen in, that the first arms are formed arc-shaped and embrace at least partly the component in the mounted position. Therefore the component is also fixed in vertical direction to the base plate of the electronic control unit, and the contact surface between the first arms and the component is increased.

Furthermore it is proposed, that the first and/or the second arms are formed as cradles, so that the component is clasped between the opposing arms and the spring forces are compensating each other.

A very easy way to manufacture the mounting arrangement can be seen in that the housing comprises a base plate made of plastic material and the arms are part of the base plate. Because of designing the arms as parts of the base plate there is no further assembly process necessary and the manufacturing costs are reduced.

The mounting arrangement can be further improved, by that several second pair of arms are provided, which are arranged in parallel forming a channel.

Furthermore it is suggested, that several pair of second arms comprise ribs and between each pair of second arms with ribs are arranged at least one pair of second arms having no ribs. The arms having no ribs improve the stability of the fixation, because they fix the component independent from its length in the direction perpendicular to the length axis and the contact surface is bigger. Using the combination of arms having no ribs and arms with ribs it is provided a good compromise in securing the component in length direction by providing ribs as axial abutments and as well as perpendicular to the length direction of the component, by the attaching arms with no ribs having a bigger contact surface to guide and secure the component.

The mounting arrangement can be further improved, by that the component is provided with circumferential grooves, in which the ribs engage in the mounted position of the component. Therefore the ribs can also act as axial abutments when the end of the component extends the arms.

It is further suggested, that the mounting arrangement is provided with a mechanical coding enabling a mounting of the component in a predetermined position. By the mechanical coding it is prevented that the component is mounted by mistake and also an automatic assembly process is possible. The predetermined position can be defined for example by the orientation of the contacts or visibility of printed information on the component.

Another preferred embodiment of the invention can be seen in that the free ends of the arms are designed with oblique surfaces providing a V-shaped entrance opening. Therefore the component can be inserted without grasping the arms but only by pressing the component into the mounting arrangement.

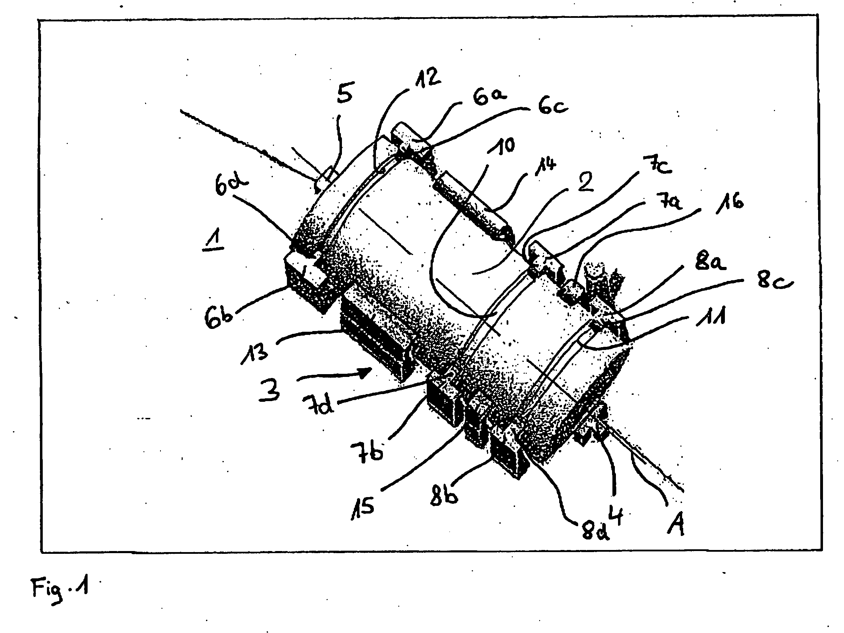

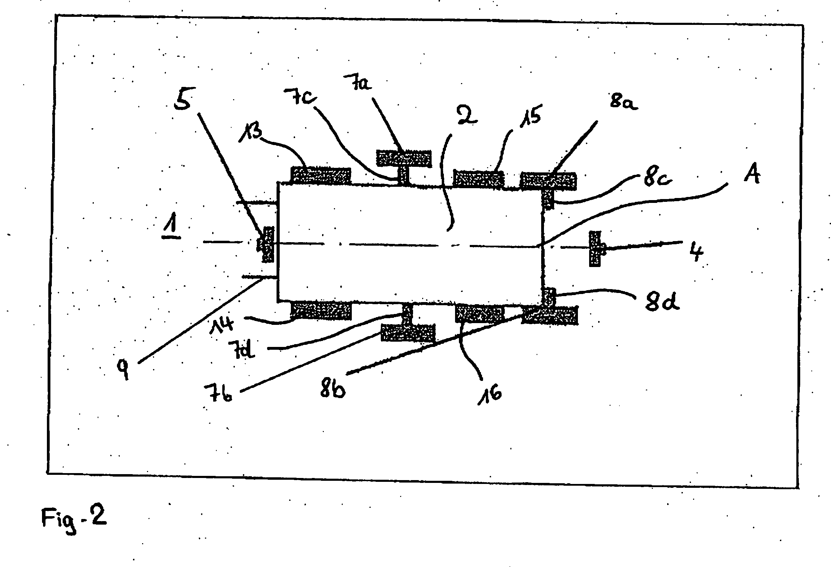

The invention is described according to two preferred embodiments shown in Fig.1 and Fig.2. The figures showing in detail:
- Fig.1:: Electric component mounted in an ECU
- Fig.2:: Electric component with shorter length mounted in an ECU

In Fig.1 is shown a mounting arrangement 3 at a base plate of a housing 1, of an electronic control unit (ECU). The housing 1 in total and/or the base plate can be made of a plastic moulding, so that the mounting arrangement 3 can be part of the housing 1 and/or the base plate and can be manufactured together in one injection moulding process. In the mounting arrangement 3 is mounted an electric component 2, here a cylindrical capacitor. The component 2 is fixed perpendicular to the length axis A by several pairs of first arms
6a, 6b, 13, 14, 7a, 7b, 15, 16, 8a and 8b. Furthermore the component 2 is fixed in parallel to the length axis A by arms 4 and 5. Because of the mounting arrangement the component 2 is fixed in the predetermined position, and the electrical connection to other not shown components is mechanical unloaded.

The arms 6a,6b,13,14,7a,7b,15,16,8a,8b,4 and 5 are flexible and may have an oblique surface at their free ends, so that the opposing arms, for example 6a and 6b, forming a V-shaped entrance opening for the component 2. The arms 4 and 5 do not need to be flexible because they are acting as simple stops in length direction but the flexibility facilitates the mounting process. The component 2 can be mounted manually without using any tools by pressing the component 2 between the arms 6a,6b,13,14,7a,7b,15,16,8a,8b,4 and 5. The arms
6a,6b,13,14,7a,7b,15,16,8a,8b,4 and 5 are bent outwardly while inserting the component 2 and fix the component 2 in the mounted position by clamping the component 2. The arms
6a, 6b, 13, 14, 7a, 7b, 15, 16, 8a, 8b, 4 and 5 can be designed arc-shaped and embrace the component 2, so that the component 2 is secured additionally in vertical direction to the base plate. Furthermore the arms 6a,6b,13,14,7a,7b,15,16,8a,8b,4 and 5 can have different lengths in length direction of the component 2 to provide sufficient contact surface to guide and clamp the component 2.

The first arms 6a,6b,7a,7b,8a and 8b are provided with ribs 6c,6d,7c,7d,8c and 8d reducing the distance between them. Between the arms 6a,6b,7a,7b,8a and 8b provided with ribs 6c,6d,7c,7d,8c and 8d in length direction of the axis A are arranged further arms 13,14,15 and 16 having no ribs. The arms 13,14,15 and 16 without ribs have the object to stabilise the mounting of the component 2, wherein the arms 13 and 14 have a bigger length in length direction of the component 2 to achieve a bigger contact surface.

At the component 2 are provided circumferential grooves 10,11 and 12, in which the ribs 6c,6d,7c,7d,8c and 8d engage. The ribs 6c,6d,7c,7d,8c and 8d give a further stabilisation in length direction of the component 2, so that the arms 4 and 5 may be deleted if the ribs 6c,6d,7c,7d,8c and 8d provide sufficient stability. The orientation of the component 2 is predetermined by the arrangement of the grooves 10,11 and 12, so that the component 2 can only be mounted in one direction. The arrangement of the grooves 10,11 and 12 and of the arms 6a,6b,7a,7b,8a and 8b with ribs 6c,6d,7c,7d,8c,8d is designed as a mechanical coding, so that a mounting in the wrong direction is prevented and an automatic assembly process is enabled.

The arms 6a,6b,13,14,7a,7b,15,16,8a,8b,4 and 5 may have an increasing stiffness beginning from their free ends. When the component 2 is pressed into the mounting arrangement, the arms 6a,6b,13,14,7a,7b,15,16,8a,8b,4 and 5 can be bent at the beginning very easy and have at the end of the mounting process the necessary stiffness to withstand the force created by the press-in process of the component 2.

In Fig.2 can be seen a slightly different embodiment having no arms 6a and 6b and a component 2 with a shorter length and no grooves. The component 2 is shorter, so that the arms 8a and 8b act with their ribs 8c and 8d as axial abutments. The arm 4 is obviously not in contact with the component 2, because of the attaching ribs 8c and 8d. When a component 2 with a further shortened length is mounted the ribs 7c and 7d will act as axial abutments. It is clearly that there may be more arms with ribs, if the mounting arrangement should be suitable for components 2 with other lengths.

## Claims

1. Mounting arrangement (3) for electric components particularly capacitors (2) in a housing (1) of an electronic control unit, that the mounting arrangement (3) comprises at least one first pair of arms (6a,6b,7a,7b,8a,8b,13,14,15,16) adapted to fix the electric component (2) perpendicular to its length axis (A) and at least one second pair of arms (4,5) adapted to fix the component (2) in its length direction, wherein at least one pair of first arms (6a,6b,7a,7b,8a,8b) comprises ribs (6c,6d,7c,7d,8c,8d) reducing the distance between the arms (6a,6b,7a,7b,8a,8b) **characterized in that** the ribs (6c,6d,7c,7d,8c,8d) are able to act as axial abutments for the component (2), when the component (2) is shorter than the distance between the second pair of arms (4,5) replacing the second arm (4) in the function to fix the component (2) in axial direction.

2. Mounting arrangement (3) according to
claim 1, **characterised in, that** the first (6a,6b,7a,7b,8a,8b,13,14,15,16) and/or second (4,5) arms are flexible.

3. Mounting arrangement (3) according to one of the preceding claims, **characterised in, that** the first arms (6a,6b,7a,7b,8a,8b,13,14,15,16) are formed arc-shaped and are able to embrace at least partly the component (2) in the mounted position.

4. Mounting arrangement (3) according to one of the preceding claims, **characterised in, that** the first (6a,6b,7a,7b,8a,8b,13,14,15,16) and/or the second (4,5) arms are formed as cradles.

5. Mounting arrangement (3) according to one of the preceding claims, **characterised in, that** the housing (1) comprises a base plate made of plastic material and the arms (4,5,6a,6b,7a,7b,8a,8b,13,14,15,16) are part of the base plate.

6. Mounting arrangement (3) according to one of the preceding claims, **characterised in, that** several pairs of first arms (6a,6b,7a,7b,8a,8b,13,14,15,16) are provided, which are arranged in parallel forming a channel.

7. Mounting arrangement (3) according to one of the preceding claims, **characterised in, that** several pairs of first arms (6a,6b,7a,7b,8a,8b) comprise ribs (6c,6d,7c,7d,8c,8d) and between at least two pairs of first arms (6a,6b,7a,7b,8a,8b) with ribs (6c,6d,7c,7d,8c,8d) is arranged at least one pair of arms (13,14,15,16) having no ribs.

8. Mounting arrangement (3) according to one of the preceding claims, **characterised in, that**
the ribs (6c,6d,7c,7d,8c,8d) are adapted to engage in circumferential grooves (10,11,12) of the component (2) in the mounted position of the component (2).

9. Mounting arrangement (3) according to one of the preceding claims, **characterised in, that** the mounting, arrangement (3) is provided with a mechanical coding adapted to enable a mounting of the component (2) in a predetermined position.

10. Mounting arrangement (3) according to one of the preceding claims, **characterised in, that** the stiffness of the first (6a,6b,7a,7b,8a,8b,13,14,15,16) and/or second (4,5) arms decreases towards their free ends.

11. Mounting arrangement (3) according to one of the preceding claims, **characterised in, that** the free ends of the arms (4,5,6a,6b,7a,7b,8a,8b,13,14,15,16) are designed with oblique surfaces **in that** way that the opposing arms (4,5,6a,6b,7a,7b,8a,8b,13,14,15,16) provide a V-shaped entrance opening for inserting the component (2).

## Patentansprüche

1. Einbauanordnung (3) für elektrische Bauteile (2), insbesondere Kondensatoren, in einem Gehäuse (1) einer elektronischen Steuereinheit, wobei die Einbauanordnung (3) mindestens ein erstes Paar von Armen (6a, 6b, 7a, 7b, 8a, 8b, 13, 14, 15, 16), welches dazu eingerichtet ist, das elektrische Bauteil (2) senkrecht zu dessen Längsachse (A) zu fixieren, und mindestens ein zweites Paar von Armen (4, 5), welches dazu eingerichtet ist, das Bauteil (2) in dessen Längsrichtung zu fixieren, umfasst, wobei mindestens ein Paar von ersten Armen (6a, 6b, 7a, 7b, 8a, 8b) Rippen (6c, 6d, 7c, 7d, 8c, 8d) umfasst, welche den Abstand zwischen den Armen (6a, 6b, 7a, 7b, 8a, 8b) verringern, **dadurch gekennzeichnet, dass** die Rippen (6c, 6d, 7c, 7d, 8c, 8d) als axiale Anschläge für das Bauteil (2) fungieren können, wenn das Bauteil (2) kürzer ist als der Abstand zwischen dem zweiten Paar von Armen (4, 5), und dabei den zweiten Arm (4) in der Funktion, das Bauteil (2) in axialer Richtung zu fixieren, ersetzen.

2. Einbauanordnung (3) nach Anspruch 1, **dadurch gekennzeichnet, dass** die ersten (6a, 6b, 7a, 7b, 8a, 8b, 13, 14, 15, 16) und/oder zweiten (4, 5) Arme flexibel sind.

3. Einbauanordnung (3) nach einem der vorhergehenden Ansprüche, **dadurch gekennzeichnet, dass** die ersten Arme (6a, 6b, 7a, 7b, 8a, 8b, 13, 14, 15, 16) bogenförmig ausgebildet sind und das Bauteil (2) in der Einbaulage zumindest teilweise umfassen können.

4. Einbauanordnung (3) nach einem der vorhergehenden Ansprüche, **dadurch gekennzeichnet, dass** die ersten (6a, 6b, 7a, 7b, 8a, 8b, 13, 14, 15, 16) und/oder die zweiten (4, 5) Arme als Klammern ausgebildet sind.

5. Einbauanordnung (3) nach einem der vorhergehenden Ansprüche, **dadurch gekennzeichnet, dass** das Gehäuse (1) eine aus Kunststoff hergestellte Grundplatte umfasst und die Arme (4, 5, 6a, 6b, 7a, 7b, 8a, 8b, 13, 14, 15, 16) Teil der Grundplatte sind.

6. Einbauanordnung (3) nach einem der vorhergehenden Ansprüche, **dadurch gekennzeichnet, dass** mehrere Paare von ersten Armen (6a, 6b, 7a, 7b, 8a, 8b, 13, 14, 15, 16) vorgesehen sind, welche unter Bildung eines Kanals parallel angeordnet sind.

7. Einbauanordnung (3) nach einem der vorhergehenden Ansprüche, **dadurch gekennzeichnet, dass** mehrere Paare von ersten Armen (6a, 6b, 7a, 7b, 8a, 8b) Rippen (6c, 6d, 7c, 7d, 8c, 8d) umfassen und zwischen mindestens zwei Paaren von ersten Armen (6a, 6b, 7a, 7b, 8a, 8b) mit Rippen (6c, 6d, 7c, 7d, 8c, 8d) mindestens ein Paar von Armen (13, 14, 15, 16) ohne Rippen angeordnet ist.

8. Einbauanordnung (3) nach einem der vorhergehenden Ansprüche, **dadurch gekennzeichnet, dass** die Rippen (6c, 6d, 7c, 7d, 8c, 8d) dazu eingerichtet sind, in der Einbaulage des Bauteils (2) in Umfangsnuten (10, 11, 12) des Bauteils (2) einzugreifen.

9. Einbauanordnung (3) nach einem der vorhergehenden Ansprüche, **dadurch gekennzeichnet, dass** die Einbauanordnung (3) mit einer mechanischen Codierung versehen ist, die dazu eingerichtet ist, einen Einbau des Bauteils (2) in einer vorbestimmten Position zu ermöglichen.

10. Einbauanordnung (3) nach einem der vorhergehenden Ansprüche, **dadurch gekennzeichnet, dass** die Steifigkeit der ersten (6a, 6b, 7a, 7b, 8a, 8b, 13, 14, 15, 16) und/oder zweiten (4, 5) Arme in Richtung auf deren freie Enden abnimmt.

11. Einbauanordnung (3) nach einem der vorhergehenden Ansprüche, **dadurch gekennzeichnet, dass** die freien Enden der Arme (4, 5, 6a, 6b, 7a, 7b, 8a, 8b, 13, 14, 15, 16) mit schrägen Oberflächen ausgebildet sind, damit die sich gegenüberliegenden Arme (4, 5, 6a, 6b, 7a, 7b, 8a, 8b, 13, 14, 15, 16) eine V-förmige Aufnahmeöffnung zum Einsetzen des Bauteils (2) bilden.

## Revendications

1. Agencement de montage (3) pour composants électriques (2), en particulier des condensateurs, dans un boîtier (1) d'une unité de commande électronique, l'agencement de montage (3) comprenant au moins une première paire de bras (6a, 6b, 7a, 7b, 8a, 8b, 13, 14, 15, 16) adaptée pour fixer le composant électrique (2) perpendiculairement à son axe longitudinal (A) et au moins une seconde paire de bras (4, 5) adaptée pour fixer le composant (2) dans sa direction longitudinale, dans lequel au moins une paire de premiers bras (6a, 6b, 7a, 7b, 8a, 8b) comprend des nervures (6c, 6d, 7c, 7d, 8c, 8d) réduisant la distance entre les bras (6a, 6b, 7a, 7b, 8a, 8b),
**caractérisé en ce que** les nervures (6c, 6d, 7c, 7d, 8c, 8d) sont susceptibles de servir de butées axiales pour le composant (2), lorsque le composant (2) est plus court que la distance entre la seconde paire de bras (4, 5), remplaçant le second bras (4) dans la fonction de fixation du composant (2) dans la direction axiale.

2. Agencement de montage (3) selon la revendication 1, **caractérisé en ce que** les premiers bras (6a, 6b, 7a, 7b, 8a, 8b, 13, 14, 15, 16) et/ou les seconds bras (4, 5) sont flexibles.

3. Agencement de montage (3) selon l'une quelconque des revendications précédentes, **caractérisé en ce que** les premiers bras (6a, 6b, 7a, 7b, 8a, 8b, 13, 14, 15, 16) se présentent sous une forme arquée et sont susceptibles de ceinturer au moins en partie le composant (2) dans la position montée.

4. Agencement de montage (3) selon l'une quelconque des revendications précédentes, **caractérisé en ce que** les premiers bras (6a, 6b, 7a, 7b, 8a, 8b, 13, 14, 15, 16) et/ou les seconds bras (4, 5) se présentent sous forme d'arceaux.

5. Agencement de montage (3) selon l'une quelconque des revendications précédentes, **caractérisé en ce que** le boîtier (1) comprend une plaque de base constituée de matériau plastique et les bras (4, 5, 6a, 6b, 7a, 7b, 8a, 8b, 13, 14, 15, 16) font partie de la plaque de base.

6. Agencement de montage (3) selon l'une quelconque des revendications précédentes, **caractérisé en ce que** plusieurs paires de premiers bras (6a, 6b, 7a, 7b, 8a, 8b, 13, 14, 15, 16) sont prévues, lesquelles paires de bras sont agencées de manière parallèle formant un couloir.

7. Agencement de montage (3) selon l'une quelconque des revendications précédentes, **caractérisé en ce que** plusieurs paires de premiers bras (6a, 6b, 7a, 7b, 8a, 8b) comprennent des nervures (6c, 6d, 7c, 7d, 8c, 8d), et entre au moins deux paires de premiers bras (6a, 6b, 7a, 7b, 8a, 8b) avec des nervures (6c, 6d, 7c, 7d, 8c, 8d) est agencée au moins une paire de bras (13, 14, 15, 16) ne possédant pas de nervures.

8. Agencement de montage (3) selon l'une quelconque des revendications précédentes, **caractérisé en ce que** les nervures (6c, 6d, 7c, 7d, 8c, 8d) sont adaptées pour venir en prise dans des gorges circonférentielles (10, 11, 12) du composant (2) dans la position montée du composant (2).

9. Agencement de montage (3) selon l'une quelconque des revendications précédentes, **caractérisé en ce que** l'agencement de montage (3) est muni d'un codage mécanique adapté pour permettre un montage du composant (2) dans une position prédéterminée.

10. Agencement de montage (3) selon l'une quelconque des revendications précédentes, **caractérisé en ce que** la rigidité des premiers bras (6a, 6b, 7a, 7b, 8a, 8b, 13, 14, 15, 16) et/ou des seconds bras (4, 5) diminue vers leurs extrémités libres.

11. Agencement de montage (3) selon l'une quelconque des revendications précédentes, **caractérisé en ce que** les extrémités libres des bras (4, 5, 6a, 6b, 7a, 7b, 8a, 8b, 13, 14, 15, 16) sont conçues avec des surfaces obliques de telle manière que les bras opposés (4, 5, 6a, 6b, 7a, 7b, 8a, 8b, 13, 14, 15, 16) fournissent une ouverture d'entrée en forme de V pour l'insertion du composant (2).
